# FASCICULE DE BREVET EUROPEEN

(11) **EP 2 106 626 B1**
(45) Date de publication et mention de la délivrance du brevet: **10.07.2013**
(21) Numéro de dépôt: 07871809.5
(22) Date de dépôt: 07.12.2007
(51) Int. Cl.: H01M 10/48, H01R 11/28, H01M 10/42, H01M 2/30

(54) **DISPOSITIF DE CONNEXION ET DE MESURE ENTRE UNE BORNE DE BATTERIE ET UN CABLE DE LIAISON ELECTRIQUE**
ANSCHLUSS- UND MESSVORRICHTUNG ZWISCHEN EINER BATTERIEKLEMME UND EINEM ELEKTRISCHEN VERBINDUNGSKABEL
CONNECTION AND MEASUREMENT DEVICE BETWEEN A BATTERY TERMINAL AND AN ELECTRICAL CONNECTING CABLE

(30) Priorité: 26.12.2006 FR 0611352
(43) Date de publication de la demande: 07.10.2009
(73) Titulaire: Valeo Etudes Electroniques, 94000 Créteil (FR)
(72) Inventeur: MAZIERE, Jean-François, 78190 Trappes (FR); CHAMALET, Philippe, 91378 Verrières Le Buisson (FR)
(74) Mandataire: de Lambilly Delorme, Marie Pierre
(86) Numéro de dépôt international: PCT/FR2007/002014
(87) Numéro de publication internationale: WO 2008/078015

(56) Documents cités:
- DE-A1-102004 007 851
- DE-A1-102004 037 874
- DE-A1-102004 055 847
- DE-A1-102004 055 848
- FR-A- 1 560 965

## Description

La présente invention se rapporte à un dispositif de connexion et de mesure électrique entre une borne de batterie et un câble électrique destiné à être alimenté par la batterie, comportant une cosse de batterie ; un élément de mesure d'un capteur de batterie, communément appelé shunt de mesure, le shunt de mesure permettant notamment la mesure du courant passant entre la cosse de batterie et le câble électrique ; et un élément isolant destiné à isoler le câble électrique de la cosse. La présente invention se rapporte également à une cosse de batterie d'un dispositif de ce genre, à un élément isolant d'un dispositif de ce genre ainsi qu'à une batterie comportant une cosse de ce genre.

On connaît dans l'art antérieur des dispositifs de ce genre qui comportent une cosse de borne de batterie, agencée pour enserrer avec contact une borne de batterie et qui comporte des parties de support de shunt qui supportent l'élément de mesure, ou shunt de mesure, classiquement sous la forme d'un barreau résistif, notamment en matière métallique. Une des extrémités du barreau shunt repose sur l'une des parties de support en étant en liaison conductrice de l'électricité avec celle ci. Une autre extrémité du shunt est en liaison conductrice de l'électricité avec le câble de batterie et est supportée par une autre partie de support de la cosse de batterie en étant, cependant, isolée électriquement de celle-ci par un élément isolant.

Pour réaliser cette isolation électrique, il est prévu dans certains systèmes un manchon isolant. L'inconvénient de ces dispositifs est que lors du démontage, notamment lorsque l'on retire le câble de sa liaison électrique avec le shunt de mesure, il peut arriver que l'on retire également du câble électrique le manchon qui l'isole de la cosse de batterie, puis que l'on remette le câble électrique en connexion électrique sans le manchon isolant, ce qui a pour conséquence un court-circuit du shunt de mesure, rendant les mesures impossibles ou imprécises.

Un autre inconvénient des dispositifs de l'art antérieur consiste en le fait que la liaison entre le câble de batterie et le shunt doit se faire suivant un angle d'orientation du câble par rapport à la cosse sensiblement fixe. Or On aimerait bien pouvoir avoir à disposition un dispositif qui permette de positionner le câble par rapport à la cosse sensiblement suivant n'importe quelle direction, ceci donnant à l'ensemble plus de possibilité de positionnement dans le compartiment moteur, comparé à l'art antérieur où l'orientation du câble ne peut quasiment pas être changée.

Les documents DE 10 2004 055848 et DE 10 2004 055847 concernent respectivement dispositif de capteur pour une batterie de voiture automobile et son procédé de fabrication.

Le document DE 10 2004 007874 décrit un dispositif pour batterie automobile comprenant un module de mesure de courant.

La présente invention vise à mettre à disposition un dispositif de connexion et de mesure entre une borne de batterie est un câble électrique, qui permet de positionner le câble batterie par rapport à la batterie suivant une direction quasiment quelconque (possibilité de plus de 300° de rotation de l'axe du câble) sans risque de création d'un cour circuit (contact direct entre la cosse et le câble).

Suivant l'invention, un dispositif de connexion est tel que défini à la revendication 1. Des perfectionnements sont définis aux revendications 2 à 9.

En prévoyant ainsi un support du shunt par une partie de prolongement en porte à faux issue de la cosse, on obtent la possibilité de réaliser l'isolation entre le câble et la cosse d'une manière très simple, notamment par un élément isolant simple comportant une plaque, tout en ayant maintenant la possibilité de positionner le câble électrique suivant une orientation pouvant varier dans un domaine d'angles très grand, notamment de l'ordre de 180 à 300°, sans risquer pour autant un court circuit.

Suivant un perfectionnement de l'invention, l'élément isolant comporte au moins une plaque disposée sur l'élément de mesure, notamment suivant un contact à plat, de manière à isoler l'élément de mesure du câble en contact également avec la dite au moins une plaque.

Suivant un mode de réalisation préféré, l'élément isolant comporte des plaques inférieure et supérieure articulées l'une à l'autre de manière à prendre en sandwich au moins partiellement le tronçon de bout de la partie de prolongement.

Ainsi, suivant l'invention, on peut maintenant effectuer un démontage complet du système et notamment du câble de la cosse de batterie et de l'élément de mesure sans que l'élément isolant n'ait à être détaché de la cosse de batterie, de sorte que lorsque l'on remonte l'ensemble on n'oublie pas cet élément isolant et on assure ainsi qu'il n'y a pas de court-circuit. En particulier, on peut maintenant réaliser un montage dans lequel le câble n'a pas besoin de passer dans un trou formé dans le corps de la cosse.

Suivant un mode de réalisation préféré, des moyens d'encliquetage sont prévus pour fixer les deux plaques de l'élément isolant au prolongement.

Suivant un mode de réalisation préféré, un tronçon de tube est issu de la face d'une des plaques supérieure et inférieure tournée vers l'intérieur de l'élément isolant lorsque les plaques sont rabattues face à face, et notamment le tronçon de bout de la partie de prolongement comporte un trou de traversée et les plaques supérieure et inférieure sont percées de trous supérieur et inférieur qui, lorsque l'élément isolant prenne en sandwich le tronçon de bout, sont en correspondance avec le trou de traversée, notamment pour permettre le passage d'un boulon de fixation.

Suivant un mode de réalisation préféré, deux tronçons de tube sont issues chacun d'une des plaques inférieure et supérieure en s'étendant l'un vers l'autre lorsque les plaques sont rabattues face à face, soit en s'emmanchant l'un dans l'autre, soit en venant en contact mutuel bout à bout, soit en restant à distance l'un de l'autre.

Suivant un mode de réalisation préféré, une des plaques inférieure ou supérieure de l'élément isolant est d'une pièce avec un boîtier destiné à enfermer l'élément de mesure et le ou les circuits électroniques de traitement des données prélevées par l'élément de mesure, notamment avec le fond du boîtier.

Suivant un mode de réalisation préféré de l'invention, un tronçon de tube est issu de la face de la plaque supérieure tournée du côté de la plaque inférieure, la section transversale du tube étant supérieure à la section transversale du trou supérieur et inférieure à la section transversale du trou inférieure.

De préférence, l'extension longitudinale du tube est sensiblement égale ou légèrement supérieure à la distance entre les deux plaques lorsqu'elles sont rabattues face à face, et notamment est sensiblement égale à l'épaisseur du tronçon de bout de la partie de prolongement qu'elles sont destinées à prendre en sandwich, ou légèrement supérieure à cette épaisseur.

Suivant un mode de réalisation préféré, un boulon de fixation traverse la plaque inférieure, ladite deuxième partie de prolongement, la plaque supérieure et une partie méplate percée de l'extrémité du câble, l'ensemble étant serré par un écrou.

La présente invention se rapporte également à une cosse de batterie suivant la revendication 11, des perfectionnements étant définis aux revendications 12 et 13.

Suivant un mode de réalisation préféré, le corps de la cosse a une épaisseur (dimension en hauteur mesurée parallèlement à l'axe de l'anneau), et au moins le tronçon de bout de la partie de prolongement a une épaisseur inférieure à l'épaisseur du corps de la cosse.

De préférence l'extension longitudinale de la partie de prolongement au delà du corps de la cosse est supérieure au diamètre de l'anneau.

La présente invention se rapporte également à un élément d'isolation destiné à être utilisé dans un dispositif suivant l'invention.

La présente invention se rapporte également à un ensemble formant batterie, comportant un boîtier, une borne, une cosse suivant l'invention entourant la borne, au moins le tronçon de bout de la partie de prolongement faisant saillie au delà du boîtier et supportant un câble batterie, notamment une extrémité méplate de celui ci, de sorte que le câble peut être tourné sur un domaine d'angle compris entre 10° et au moins 180°, en particulier entre 10° et 300°, sans pouvoir venir en contact avec le corps annulaire de la cosse.

La présente invention se rapporte également à un ensemble formant batterie suivant la revendication 10.

Suivant un mode de réalisation préféré, une extrémité libre du câble est en contact avec l'élément de mesure au dessus du tronçon de bout de la partie de prolongement.

Aux figures, on décrit maintenant un mode de réalisation préféré de l'invention donné uniquement à titre d'exemple.
La figure 1 représente une vue d'ensemble d'un système de batterie d'un véhicule automobile suivant l'invention ;
la figure 2 est une vue en perspective d'un canon d'isolation clipable formant élément isolant tel qu'on le voit en utilisation à la figure 1 ; et
la figure 3 est une vue en perspective d'un mode de réalisation en variante dans lequel le canon d'isolation clipable représenté à la figure 2 est réalisé d'une pièce avec le boîtier du capteur.

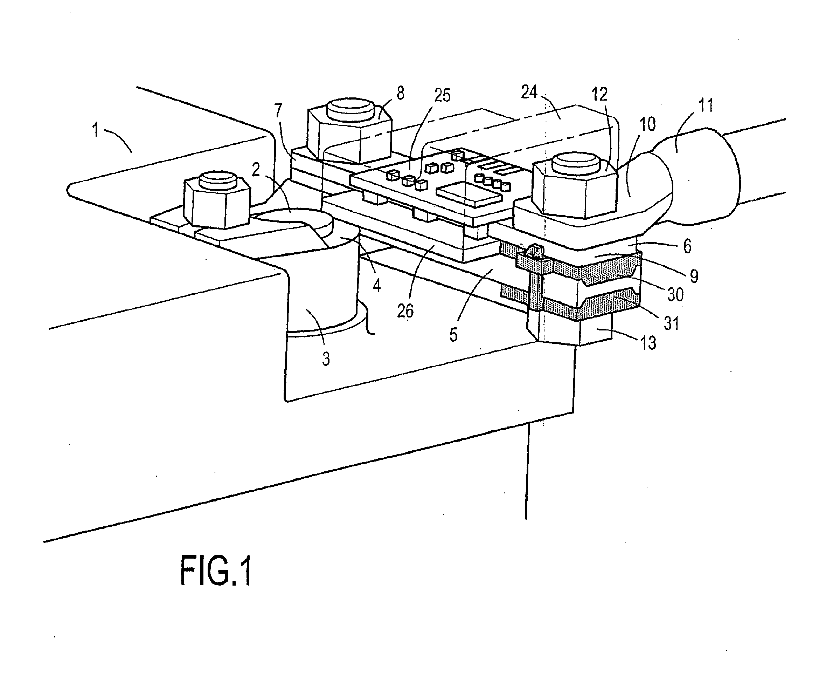

A la figure 1, on peut voir un système de batterie constitué d'une batterie 1 ayant un boîtier dont est issue une borne 2 qui est entourée par une cosse de batterie ayant un élément ou corps 4 formant un anneau entourant la borne de batterie 2. Du corps 4 fait saillie un prolongement 5 en forme de plaque parallélépipédique oblongue dans la direction s'éloignant du corps 4, et ayant une face supérieure et une face inférieure perpendiculaires à l'axe vertical de la borne. Un élément 6 de mesure ou shunt de mesure sous la forme d'un barreau parallélépipédique est supporté à plat par la plaque de prolongement 5.

Une partie d'extrémité 7 proximale de l'élément de mesure est en contact électrique direct avec le prolongement 5, et donc avec la borne 2. La fixation de cette extrémité 7 avec le prolongement est assurée par un système à vis et écrou 8. L'autre partie d'extrémité 9 distale de l'élément de mesure est en contact électrique avec une partie 10 méplate d'extrémité d'un câble 11 électrique de batterie. Leur fixation mutuelle est assurée également par un système à vis et écrou 13, 12.

La plaque 5 de prolongement comporte à chacune de ses parties d'extrémité des trous traversants. Ceux-ci ne sont pas visibles à la figure. Ils se trouvent à un niveau permettant le passage des vis ou écrous de fixation mentionnés ci dessus. De même, l'élément de mesure 6 comporte des trous de traversée en regard des trous de traversée du prolongement 5. La partie méplate 10 du câble électrique comporte également un trou traversant qui peut venir en regard des autres trous pour assurer également la fixation avec le prolongement 5 par la vis 13 et l'écrou 12.

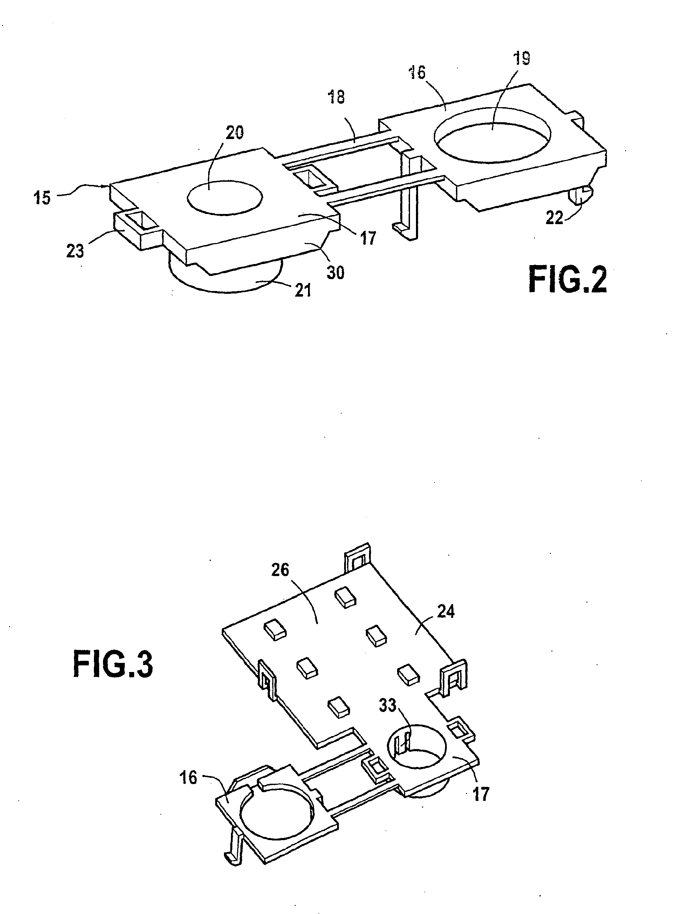

Un élément 15 isolant assure l'isolation électrique entre une partie d'extrémité du prolongement 5 et l'élément de mesure 6. Cet élément 15 isolant comporte une première plaque 16 (plaque inférieure) et une deuxième plaque 17 (plaque supérieure) reliées par des charnières 18 en forme de bandes souples pouvant être pliées pour rabattre les deux plaques en position se faisant mutuellement face ou dépliées pour les éloigner l'une de l'autre (comme représenté à la figure 2).

La plaque 16 inférieure est percée d'un trou 19. La plaque 17 est percée d'un trou 20. Un cylindre circulaire creux ou tube 21 fait saillie de la plaque 17 perpendiculairement à celle-ci. Le cylindre 21 a une diamètre suffisamment petit pour pouvoir passer à travers le trou traversant formé à l'extrémité 9 du prolongement 5 en regard de la partie 10 méplate du câble électrique. Le diamètre du cylindre 21 creux est également suffisamment petit pour pouvoir pénétrer dans le trou 19, de préférence, par ajustement serré. Suivant une ou des variantes, on peut également prévoir que le cylindre soit issu de la plaque 16 au lieu de la plaque 17, ou à la place d'un cylindre unique, on peut prévoir deux cylindres issus chacun d'une plaque 16, 17 respective et dont l'un s'emmanche dans l'autre ou qui viennent en contact mutuel bout à bout (en ayant chacun une dimension telle que la somme de leur hauteur est égale à la distance entre les deux plaques lorsqu'elles sont rabattues l'une sur l'autre et clippées l'une à l'autre. On peut également prévoir que les deux cylindre soit tels qu'ils ne s'étendent pas jusqu'au point de venir en contact bout à bout l'un avec l'autre et ne laissant entre eux une zone médiane à nue. Deux tenons 22 de clippage font saillie de la première plaque 16, tandis que la deuxième plaque 17 comporte des anses 23 associées aux tenons de clippage 22 pour assurer un clippage ou encliquetage mutuel des deux plaques après qu'on les ait rabattues l'une sur l'autre avec introduction du cylindre 21 dans le trou 19. Le diamètre du trou 20 est inférieure au diamètre extérieur du tube 21.

Deux languettes 30 et 31 font saillie de chacune des plaques du côté destiné à se trouver à l'extrémité distale du prolongement 5. A la place de ces languettes, on pourrait prévoir un tenon de clippage et une anse supplémentaires (non représenté aux figures) identiques aux tenons et anses 22 et 23. On s'assure ainsi d'une protection contre un contact câble 11 - prolongement 5 même dans le cas où le câble s'étend non pas horizontalement comme à la figure 1, mais verticalement.

En outre, à la figure 3 il est prévu une languette clipable comportant un ergot 33 destiné à se clipper dans un évidemment correspondant formé dans la vis 13 pour bloquer celle ci et la rendre imperdable.

A la figure 1, on peut voir l'élément 15 isolant en utilisation. La plaque 17 supérieure est en contact avec la face supérieure d'une partie de l'extrémité 9 du prolongement 5, tandis que la plaque 16 inférieure est en contact avec la face inférieure de ladite partie de l'extrémité 9 du prolongement 5. Cette partie est ainsi prise en sandwich entre les deux plaques, tandis que le cylindre 21 creux traverse le trou traversant formé dans le prolongement à son extrémité 9, en s'étendant d'une plaque à l'autre. Les deux plaques sont solidarisées l'une à l'autre par coopération des ergots d'encliquetage 22 avec les anses 23. L'axe de la vis 13, en contact électrique avec la partie méplate 10 du câble et avec l'élément de mesure, n'est en revanche pas en contact électrique avec le prolongement 5, en raison de l'isolation électrique réalisée par le tube 21 et les plaques 16 et 17.

Un boîtier 24 comportant le capteur associé à l'élément de mesure 6 est fixé à cet élément de mesure en étant traversé par celui ci. Le boîtier est posé sur le prolongement 5 par son fond qui assure ainsi également l'isolation entre la partie de milieu de l'élément de mesure et la partie de prolongement et comporte un circuit 25 électrique qui utilise les informations obtenues par l'élément de mesure 6.

Suivant un mode de réalisation préféré de l'invention et représenté à la figure 3, l'élément isolant est solidaire du boîtier 24, l'une des plaques (ici la plaque 17 supérieure) de l'élément d'isolation 15 étant issue du boîtier 24, notamment d'une de ses parois, ici la paroi formant le fond 26. Ainsi lors d'un remontage, lorsque l'on repositionne le capteur, on ne peut pas oublier non plus de remettre l'élément isolant.

La partie 5 de prolongement s'étend latéralement au delà du boîtier 1 de la batterie. En particulier le tronçon de la partie 5 de prolongement qui est pris en sandwich fait saillie latéralement au delà du boîtier de la batterie 1. Ce tronçon est séparé du corps de cosse par le reste de la partie de prolongement, qui est en porte à faux par rapport à ce corps de cosse.

L'épaisseur (mesurée dans la direction verticale à la figure, ou direction de l'axe de l'anneau ou de la borne) du corps 4 de la cosse est supérieure, en particulier sensiblement supérieure, à celle de la partie 5 de prolongement, notamment de son extrémité en porte à faux.

## Revendications

1. Dispositif de connexion et de mesure entre une borne (2) de batterie et un câble (11) électrique, comportant une cosse de batterie comportant un corps (4) formant un anneau destiné à entourer une borne (2) de batterie (1), une partie (5) de prolongement étant issue du corps, la partie de prolongement ayant une face supérieure perpendiculaire à l'axe de l'anneau, la partie de prolongement étant de forme oblongue, notamment sous la forme d'un barreau parallélépipédique, et ayant un tronçon de bout longitudinal séparé du corps par le reste de la partie de prolongement ; un élément (6, 7, 9) de mesure en forme de barreau oblong, dont une première (7) partie d' extrémité est en liaison électrique avec la cosse en étant supportée par la partie (5) de prolongement de la cosse et dont une deuxième partie (9) d'extrémité est destinée a être en liaison électrique avec le câble en étant supportée par la partie de prolongement ; et un élément (15) isolant destiné à isoler le câble de la cosse, **caractérisé en ce que** la deuxième partie (9) d'extrémité de l'élément de mesure est supportée par le tronçon de bout.

2. Dispositif suivant la revendication 1, **caractérisé en ce que** l'élément isolant comporte au moins une plaque disposée sur l'élément de mesure, notamment suivant un contact à plat, de manière à isoler l'élément de mesure du câble en contact également avec la dite au moins une plaque.

3. Dispositif suivant la revendication 1 ou 2, **caractérisé en ce que** l'élément isolant comporte des plaques inférieure et supérieure articulées l'une à l'autre de manière à prendre en sandwich au moins partiellement le tronçon de bout de la partie de prolongement .

4. Dispositif suivant la revendication 3, **caractérisé en ce que** des moyens (22, 23) d' encliquetage sont prévus pour fixer les deux plaques de l'élément isolant au prolongement (5)

5. Dispositif suivant l'une des revendications 3 à 4, **caractérisé en ce que** le tronçon de bout de la partie de prolongement comporte un trou de traversée et les plaques supérieure et inférieure sont percées de trous supérieur et inférieur qui, lorsque l'élément isolant prend en sandwich le tronçon de bout, sont en correspondance avec le trou de traversée, notamment pour permettre le passage d'un boulon de fixation.

6. Dispositif suivant l'une des revendications 3 à 5, **caractérisé en ce qu'**un tronçon de tube est issu de la face d'une des plaques supérieure et inférieure tournée vers l'intérieur de l'élément isolant lorsque les plaques sont rabattues face à face.

7. Dispositif suivant l'une des revendications 3 à 5, **caractérisé en ce que** deux tronçons de tube sont issus chacun d'une des plaques inférieure et supérieure en s' étendant l'un vers l'autre lorsque les plaques sont rabattues face à face, soit en s'emmanchant l'un dans l'autre, soit en venant en contact mutuel bout à bout, soit en restant à distance l'un de l'autre.

8. Dispositif suivant l'une des revendications 1 à 7, **caractérisé en ce que** l'extrémité libre (10) du câble est en contact avec l'élément de mesure au dessus du tronçon de bout.

9. Dispositif suivant l'une des revendications 3 à 8, **caractérisé en ce que** l'une des plaques inférieure ou supérieure de l'élément isolant est d'une pièce avec un boîtier destiné à enfermer élément de mesure et le ou les circuits électroniques (25) de traitement des données prélevées par l'élément de mesure, notamment avec le fond (26) du boîtier (24).

10. Ensemble formant batterie, comportant un boîtier, une borne et un dispositif suivant l'une des revendications 1 a 9, la cosse entourant la borne, au moins le tronçon de bout de la partie de prolongement faisant saillie au delà du boîtier et supportant un câble batterie, notamment une extrémité méplate de celui ci, de sorte que le câble peut être tourné sur un domaine d'angle compris entre 10[deg.] et au moins 180[deg.], en particulier entre 10[deg.] et 300[deg.], sans pouvoir venir en contact avec le corps annulaire de la cosse.

## Patentansprüche

1. Verbindungs- und Messvorrichtung zwischen einem Batteriepol (2) und einem Stromkabel (11), die eine Batterieklemme, die einen Körper (4) aufweist, der einen Ring bildet, welcher dazu bestimmt ist, einen Pol (2) einer Batterie (1) zu umgeben, wobei ein Verlängerungsteil (5) aus dem Körper hervorgeht, wobei der Verlängerungsteil eine Oberseite lotrecht zur Achse des Rings hat, wobei der Verlängerungsteil von länglicher Form ist, insbesondere in Form eines parallelepipedischen Stabs, und einen Längsendabschnitt hat, der vom Körper durch den Rest des Verlängerungsteils getrennt ist; ein Messelement (6, 7, 9) in Form eines länglichen Stabs, von dem ein erster Endteil (7) mit der Klemme in elektrischer Verbindung steht und vom Verlängerungsteil (5) der Klemme getragen wird, und von dem ein zweiter Endteil (9) dazu bestimmt ist, mit dem Kabel in elektrischer Verbindung zu stehen, indem er vom Verlängerungsteil getragen wird; und ein Isolierelement (15) aufweist, das dazu bestimmt ist, das Kabel von der Klemme zu isolieren, **dadurch gekennzeichnet, dass** der zweite Endteil (9) des Messelements vom Endabschnitt getragen wird.

2. Vorrichtung nach Anspruch 1, **dadurch gekennzeichnet, dass** das Isolierelement mindestens eine Platte aufweist, die auf dem Messelement angeordnet ist, insbesondere gemäß einem Flachkontakt, um das Messelement vom Kabel zu isolieren, das ebenfalls mit der mindestens einen Platte in Kontakt ist.

3. Vorrichtung nach Anspruch 1 oder 2, **dadurch gekennzeichnet, dass** das Isolierelement eine untere und eine obere Platte aufweist, die aneinander angelenkt sind, um den Endabschnitt des Verlängerungsteils zumindest teilweise zwischen sich einzuklemmen.

4. Vorrichtung nach Anspruch 3, **dadurch gekennzeichnet, dass** Einrasteinrichtungen (22, 23) vorgesehen sind, um die zwei Platten des Isolierelements an der Verlängerung (5) zu befestigen.

5. Vorrichtung nach einem der Ansprüche 3 bis 4, **dadurch gekennzeichnet, dass** der Endabschnitt des Verlängerungsteils ein Durchgangsloch aufweist, und dass in die obere und untere Platte obere und untere Löcher gebohrt sind, die, wenn das Isolierelement den Endabschnitt einklemmt, mit dem Durchgangsloch in Verbindung stehen, insbesondere um den Durchgang eines Befestigungsbolzens zu ermöglichen.

6. Vorrichtung nach einem der Ansprüche 3 bis 5, **dadurch gekennzeichnet, dass** ein Rohrabschnitt aus der Seite einer der oberen und unteren Platten hervorgeht, die zur Innenseite des Isolierelements weist, wenn die Platten einander gegenüber umgeklappt sind.

7. Vorrichtung nach einem der Ansprüche 3 bis 5, **dadurch gekennzeichnet, dass** zwei Rohrabschnitte je aus einer der unteren und oberen Platte hervorgehen, indem sie sich zueinander erstrecken, wenn die Platten einander gegenüber umgeklappt sind, entweder, indem sie sich ineinander fügen, oder indem sie stumpf gegeneinander in Kontakt kommen, oder indem sie in Abstand zueinander bleiben.

8. Vorrichtung nach einem der Ansprüche 1 bis 7, **dadurch gekennzeichnet, dass** das freie Ende (10) des Kabels mit dem Messelement oberhalb des Endabschnitts in Kontakt ist.

9. Vorrichtung nach einem der Ansprüche 3 bis 8, **dadurch gekennzeichnet, dass** eine der unteren oder oberen Platten des Isolierelements mit einem Gehäuse, das dazu bestimmt ist, das Messelement und die Elektronikschaltung(en) (25) zur Verarbeitung der vom Messelement entnommenen Daten zu umschließen, insbesondere mit dem Boden (26) des Gehäuses (24), aus einem Stück besteht.

10. Eine Batterie formende Einheit, die ein Gehäuse, einen Pol und eine Vorrichtung nach einem der Ansprüche 1 bis 9 aufweist, wobei die Klemme den Pol umgibt, wobei mindestens der Endabschnitt des Verlängerungsteils über das Gehäuse vorsteht und ein Batteriekabel, insbesondere ein abgeflachtes Ende von diesem, trägt, so dass das Kabel um einen Winkelbereich gedreht werden kann, der zwischen 10[Grad] und mindestens 180[Grad], insbesondere zwischen 10[Grad] und 300[Grad], liegt, ohne mit dem ringförmigen Körper der Klemme in Kontakt kommen zu können.

## Claims

1. A connecting and measuring device between a battery terminal post (2) and an electrical cable (11), including a battery terminal including a body (4) forming a ring intended to surround a terminal post (2) of a battery (1), an extension portion (5) extending from the body, the extension portion having an upper face perpendicular to the axis of the ring, the extension portion being of oblong shape, in particular in the form of a parallelepiped-shaped bar, and having a longitudinal end section separated from the body by the rest of the extension portion; a measuring member (6, 7, 9) in the form of an oblong bar, a first end part (7) of which is electrically connected to the terminal, being supported by the extension portion (5) of the terminal, and a second end part (9) of which is intended to be electrically connected to the cable, being supported by the extension portion; and an insulating member (15) intended to insulate the cable from the terminal, **characterized in that** the second end part (9) of the measuring element is supported by the end section.

2. Device according to Claim 1, **characterized in that** the insulating member includes at least one plate disposed on the measuring element, notably in flat contact therewith, so as to insulate the measuring element from the cable also in contact with said at least one plate.

3. Device according to either one of Claims 1 and 2, **characterized in that** the insulating member includes upper and lower plates hinged to each other so as to sandwich at least partially the end section of the extension portion.

4. Device according to Claim 3, **characterized in that** means (22, 23) are provided for fixing the two plates of the insulating member to the extension (5).

5. Device according to either one of Claims 3 and 4, **characterized in that** the end section of the extension portion includes a through-hole and the upper and lower plates are perforated with upper and lower holes which when the insulating member sandwiches the end section are in correspondence with the through-hole, notably to allow the passage of a fixing bolt.

6. Device according to any one of Claims 3 to 5, **characterized in that** a tube section extends from the face of one of the upper and lower plates facing the interior of the insulating member when the plates are folded face to face.

7. Device according to any one of Claims 3 to 5, **characterized in that** two tube sections each extend from one of the lower and upper plates and towards one another when the plates are folded face to face, nesting one in the other or coming into end-to-end contact with one another or remaining at a distance from one another.

8. Device according to any one of Claims 1 to 7, **characterized in that** the free end (10) of the cable is in contact with the measuring element above the end section.

9. Device according to any one of Claims 3 to 8, **characterized in that** one of the upper or lower plates of the insulating member is integral with a housing intended to enclose the measuring element and the electronic circuit or circuits (25) processing data collected by the measuring element, notably with the bottom (26) of the housing (24).

10. Battery assembly including a housing, a terminal post and a device according to any one of Claims 1 to 9, the terminal surrounding the terminal post, at least the end section of the extension portion projecting beyond the housing and supporting a battery cable, notably a flattened end of the latter, so that the cable can be rotated in an angular range between 10 degrees and at least 180 degrees, in particular between 10 degrees and 300 degrees, without being able to come into contact with the annular body of the terminal.
